# DEMANDE DE BREVET EUROPEEN

(11) **EP 1 274 138 A1**
(43) Date de publication de la demande: **08.01.2003**
(21) Numéro de dépôt: 02291508.6
(22) Date de dépôt: 17.06.2002
(51) Int. Cl.: H01M 2/10, G12B 9/04

(54) **Dispositif de verrouillage/déverrouillage d'un couvercle amovible sur un boitier**

(30) Priorité: 29.06.2001 FR 0108629
(71) Demandeur: ALCATEL, 75008 Paris (FR)
(72) Inventeur: Barthelet, Philippe, 92270 Bois-Colombes (FR); Durand, Gilles, 95610 Eragny (FR); Jouffret, Yves, 95500 Gonesse (FR); Lautrec, Olivier, 92230 Gennevilliers (FR)
(74) Mandataire: Korakis-Ménager, Sophie

(57) **Abrégé**

La présente invention concerne un dispositif de verroulllage/déverrouillage d'un couvercle (1) amovible dit élément amovible sur un boîtier (2) dit élément fixe, comprenant un verrou (3) prévu sur l'un des éléments et coulissant d'une position verrouillée où une extrémité du verrou est en contact avec l'autre élément vers une position déverrouillée où cette extrémité n'est pas en contact avec l'autre élément, ledit verrou (3) comportant une surface de préhension (3B) pour commander son coulissement.

Selon l'invention, il comporte un moyen de blocage du verrou (3) en position déverrouillée au moins jusqu'à déplacement du couvercle (1).

## Description

La présente invention se rapporte à un dispositif de verrouillage/déverrouillage d'un couvercle amovible sur un boîtier

Elle concerne plus précisément un dispositif de verrouillage/déverrouillage d'un couvercle amovible dit élément amovible sur un boîtier dit élément fixe, comprenant un verrou prévu sur l'un des éléments et coulissant d'une position verrouillée où une extrémité du verrou est en contact avec l'autre élément vers une position déverrouillée où cette extrémité n'est pas en contact avec l'autre élément, ledit verrou comportant une surface de préhension pour commander son coulissement.

De tels verrous sont couramment utilisés par exemple pour la fermeture de casiers à batteries dans les appareils électroménagers et dans les téléphones portables pour la mise en place du bloc batterie.

Selon un mode de réalisation connu, un tel verrou est de type bouton poussoir, coulissant parallèlement au plan du couvercle et est sollicité vers la position verrouillée par un ressort de pression solidaire de l'élément portant le verrou. Il s'agit donc pour ouvrir ou ôter le couvercle de coulisser le verrou à l'encontre de l'effort de ce ressort et de le maintenir dans cette position déverrouillée tout en déplaçant le couvercle.

Selon un autre mode de réalisation connu, le verrou est de type bouton à pression, coulissant perpendiculairement au plan du couvercle et agit par déformation propre du verrou porté par une lame plastique. Il s'agit donc pour ouvrir ou ôter le couvercle de presser le verrou à l'encontre de l'effort de cette lame plastique et de le maintenir dans cette position déverrouillée tout en déplaçant le couvercle.

Cet art antérieur s'avère peu ergonomique car nécessite deux actions simultanées de la part de l'utilisateur.

La présente invention résout ce problème en équipant le verrou d'un état stable de déverrouillage.

Pour ce faire, conformément à l'invention, le dispositif comporte un moyen de blocage du verrou en position déverrouillée au moins jusqu'à déplacement du couvercle.
Par ailleurs, il comporte un moyen de blocage du verrou en position déverrouillée au moins jusqu'à déplacement du couvercle, et le moyen de blocage comporte un élément élastique solidaire de l'un des éléments et s'engage, en position déverrouillée, dans une cavité de blocage prévue sur l'autre élément.De préférence, cet état stable est provisoire et ledit moyen de blocage est désactivé dès déplacement du couvercle.

De cette façon, la fermeture du couvercle se fait par simple remise en place de celui-ci, sans manipulation du verrou.

Selon le mode de réalisation préféré, le couvercle est déplacé par pivotement sur son côté opposé au verrou, le verrou est coulissant parallèlement au plan du couvercle et ledit moyen est constitué par un agencement de ressort.

Selon une première variante, ledit élément élastique est fixé au boîtier et de forme telle qu'il autorise le coulissement du verrou de la position verrouillée à la position déverrouillée où il s'engage dans une cavité ménagée dans le couvercle.

De préférence, ledit élément élastique est une lame et une extrémité de la lame est coincée dans une partie solidaire du boîtier, la lame ayant une forme courbe afin d'être logée comprimée sous le couvercle et présentant une partie repliée formant protubérance dirigée vers le couvercle, son autre extrémité étant libre.

Selon une seconde variante, ledit élément élastique est solidaire du couvercle et de forme telle qu'il autorise le coulissement du verrou de la position verrouillée à la position déverrouillée où il s'engage dans une cavité ménagée dans le boîtier.

Dans ce cas, de préférence, ledit élément élastique pousse également le verrou vers sa position verrouillée jusqu'à la position de déverrouillage.

De préférence, ledit élément élastique est une lame et une extrémité de ladite lame est solidaire d'une seconde lame élastique perpendiculaire au sens de déplacement du verrou, quand elle n'est pas sollicitée, et en butée contre deux plots agencés sur le couvercle et ladite lame a une forme courbe afin d'être logée comprimée sous le couvercle et présente une partie repliée formant protubérance dirigée vers le boîtier, son extrémité étant libre.

Dans tous les cas, éventuellement, un ressort de pression solidaire du couvercle peut solliciter le verrou en position verrouillée.

L'invention concerne également un téléphone portable équipé d'un dispositif de verroulllage/déverroulllage tel que précédemment précisé, ledit élément amovible étant le couvercle d'un casier formant ledit élément fixe et destiné à recevoir une batterie.

L'invention est décrite ci-après plus en détail à l'aide de figures ne représentant que des modes de réalisation préférés de l'invention.

La figure 1 est une vue en section longitudinale d'une première variante de réalisation du dispositif conforme à l'invention, en position verrouillée.

La figure 2 est une vue en section identique en position déverrouillée.

La figure 3 est une vue en section identique en position de couvercle déplacé.

Les figures 4A et 4B sont des vues en section longitudinale et schématique en plan d'une seconde variante de réalisation du dispositif conforme à l'invention en position verrouillée.

Les figures 5A et 5B sont des vues en section longitudinale et schématique en plan d'une seconde variante de réalisation du dispositif conforme à l'invention en position déverrouillée.

Les figures 6A et 6B sont des vues en section longitudinale et schématique en plan d'une seconde variante de réalisation du dispositif conforme à l'invention en position de couvercle déplacé.

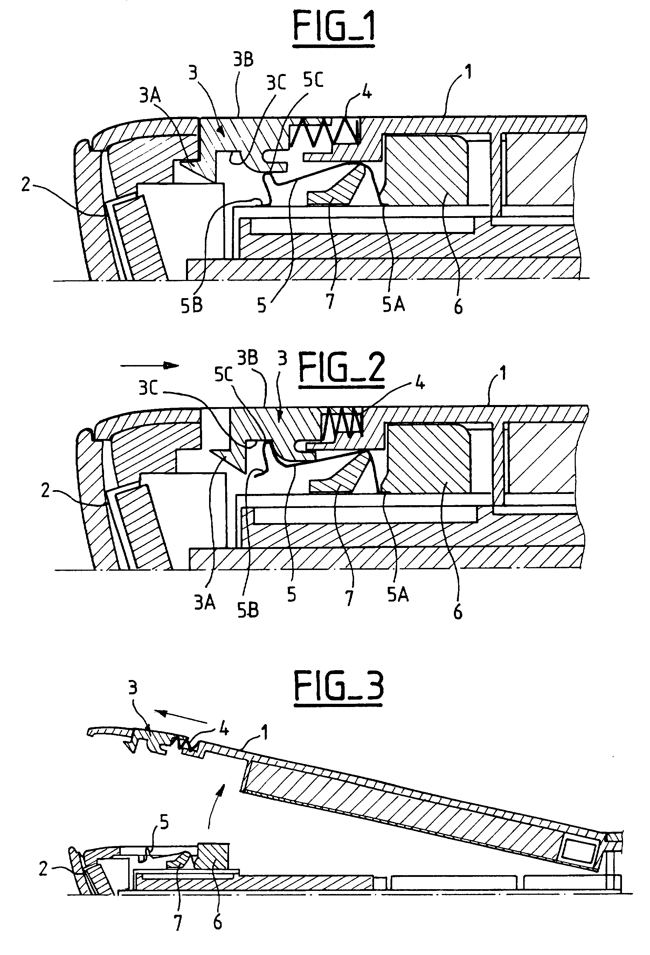

Comme représenté sur les figures 1 à 3, un couvercle 1 amovible est monté sur un boîtier 2 et est verrouillé sur ce boîtier 2 par un verrou 3 lui-même monté sur le couvercle 1. Ce verrou 3 est coulissant parallèlement au plan du couvercle 1 d'une position verrouillée représentée sur la figure 1 à une position déverrouillée représentée sur la figure 2. De façon connue en soi, il est sollicité vers la position verrouillée par un ressort hélicoïdal 4 disposé à son extrémité et en appui sur le couvercle 1. A son autre extrémité, le verrou 3 présente un crochet 3A qui vient s'encastrer sous une partie du boîtier 2 en position verrouillée pour bloquer le couvercle sur le boîtier. Lors de la translation du verrou, ce crochet 3A est dégagé du boîtier permettant le déplacement du couvercle 1.

Le verrou 3 comporte une surface de préhension 3B pour commander son coulissement, en général cette surface présente des nervures moulées assurant cette préhension.

Le couvercle 1 dans cet exemple de réalisation est déplacé par pivotement autour de son côté opposé au verrou comme visible sur la figure 3.

Ce dispositif de verrouillage/déverrouillage comporte un moyen de blocage du verrou 3 en position déverrouillée jusqu'à déplacement du couvercle 1 qui est désactivé dès déplacement du couvercle 1.

Ce moyen est constitué par un agencement de ressort 5.

Cet agencement comporte une lame élastique 5 solidaire du boîtier 1. Cette lame élastique est de forme telle qu'elle autorise le coulissement du verrou de la position verrouillée à la position déverrouillée où elle s'engage dans une cavité de blocage ménagée dans le couvercle.

Plus précisément, une extrémité de la lame 5A est coincée dans une partie 6 solidaire du boîtier 2. Elle a une forme courbe afin d'être logée comprimée sous le couvercle 1 et son autre extrémité 5B est libre. Elle présente une partie repliée 5C formant protubérance dirigée vers le couvercle 1. Avantageusement, elle est supportée par une partie 7 solidaire du boîtier 2.

C'est cette partie repliée 5C qui est destinée à venir s'engager dans une cavité du couvercle en position déverrouillée.

Plus précisément, c'est le verrou 3 qui porte cette cavité de blocage 3C disposée à proximité de son extrémité portant le crochet 3A.

Le fonctionnement de ce dispositif de verrouillage/déverrouillage est le suivant :

Par poussée grâce à la surface de préhension 3B, le verrou 3 est poussé à l'encontre de la force du ressort 4 et le crochet 3A se dégage du boîtier. La lame 5 durant cette translation glisse sous le verrou jusqu'à engagement de sa partie repliée 5C dans la cavité de blocage 3C comme représenté sur la figure 2. Le verrou 3 est alors bloqué en position de déverrouillage et il n'est plus nécessaire que l'utilisateur le maintienne. Le couvercle peut alors être déplacé par pivotement et lors de ce déplacement, la lame 5 est dégagée de la cavité 3C et le verrou revient automatiquement en position verrouillée sous l'action du ressort 4 comme représenté sur la figure 3. De par la forme du crochet 3A, il suffit pour refermer le couvercle de le pousser dans le boîtier, le crochet 3A glissant sur le boîtier à l'encontre de l'effort du ressort 4 et venant se bloquer dans le boîtier.

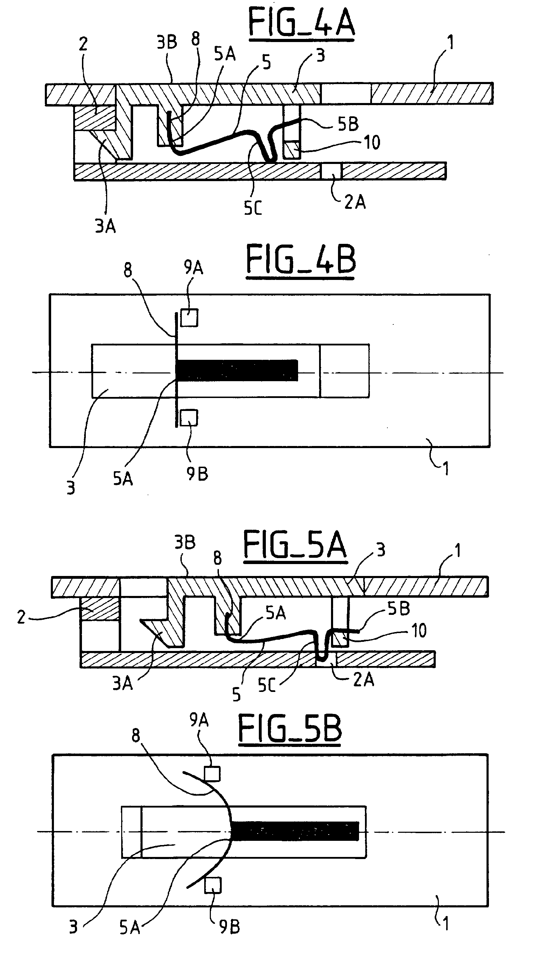

Suivant un principe équivalent, il est possible de conformer la lame élastique de telle sorte qu'elle assure et le blocage du verrou en position déverrouillée et la poussée du verrou en position verrouillée. Un exemple d'un tel mode de réalisation est décrit sur les figures 4 à 6.

Selon ce mode de réalisation, une lame élastique 5 est solidaire du couvercle 1 et de forme telle qu'elle autorise le coulissement du verrou 3 de la position verrouillée à la position déverrouillée où elle s'engage dans une cavité 2A ménagée dans le boîtier 2.

Plus précisément, une extrémité de la lame 5A est solidaire d'une seconde lame élastique 8 perpendiculaire au sens de déplacement du verrou, quand elle n'est pas sollicitée. De préférence, ces deux lames 5 et 8 sont constituées d'une seule bande métallique découpée et pliée.

La lame 8 est en butée contre deux plots 9A et 9B agencé sur le couvercle 1.

La lame 5, quant à elle, a une forme courbe afin d'être logée comprimée sous le couvercle 1 et son extrémité 5B est libre. Elle présente une partie repliée 5C formant protubérance dirigée vers le boîtier 2. Avantageusement, elle est supportée par une partie 10 solidaire du couvercle 1.

C'est cette partie repliée 5C qui est destinée à venir s'engager dans la cavité de blocage 2A du boîtier en position déverrouillée.

Le fonctionnement de ce dispositif de verrouillage/déverrouillage est le suivant :

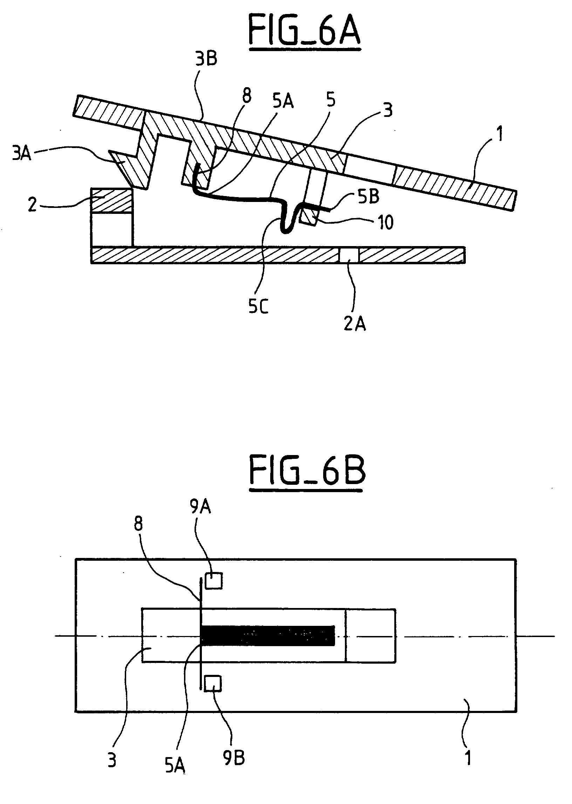

Par poussée grâce à la surface de préhension 3B, le verrou 3 est poussé à l'encontre de la force de la seconde lame 8 qui se déforme, toujours en butée contre les plots 9A et 9B et le crochet 3A se dégage du boîtier. La lame 5 durant cette translation glisse sous le verrou jusqu'à engagement de sa partie repliée 5C dans la cavité de blocage 2A comme représenté sur les figures 5A et 5B. Le verrou 3 est alors bloqué en position de déverrouillage et il n'est plus nécessaire que l'utilisateur le maintienne. Le couvercle peut alors être déplacé par pivotement et lors de ce déplacement, la lame 5 est dégagée de la cavité 2A et le verrou revient automatiquement en position verrouillée sous l'action de la seconde lame 8 qui revient à sa position de repos toujours en butée contre les plots 9A et 9B, comme représenté sur les figures 6A et 6B. De par la forme du crochet 3A, il suffit pour refermer le couvercle de le pousser dans le boîtier, le crochet 3A glissant sur le boîtier à l'encontre de l'effort de la seconde lame 8 et venant se bloquer dans le boîtier.

Eventuellement, avec un tel agencement, un ressort de pression solidaire du couvercle sollicitant le verrou en position verrouillée peut être ajouté.

Dans le mode de réalisation préféré ci-dessus décrit, l'élément élastique 5 est une lame élastique mais un autre type d'élément élastique, tel qu'un fil ou câble élastique peut être utilisé.

L'application préférée du dispositif de verrouillage/déverrouillage ci-dessus décrit est le verrouillage/déverrouillage du couvercle d'un casier destiné à recevoir une batterie, dans un téléphone portable raccordé à un réseau fixe ou cellulaire. Dans la description ci-dessus l'élément amovible 1 est ledit couvercle et l'élément fixe 2 ledit casier.

## Revendications

1. Dispositif de verrouillage/déverrouillage d'un couvercle (1) amovible dit élément amovible sur un boîtier (2) dit élément fixe, comprenant un verrou (3) prévu sur l'un des éléments et coulissant d'une position verrouillée où une extrémité du verrou est en contact avec l'autre élément vers une position déverrouillée où cette extrémité n'est pas en contact avec l'autre élément, ledit verrou (3) comportant une surface de préhension (3B) pour commander son coulissement, **caractérisé en ce qu'**il comporte un moyen de blocage du verrou (3) en position déverrouillée au moins jusqu'à déplacement du couvercle (1) et **en ce que** le moyen de blocage comporte un élément élastique (5) solidaire de l'un des éléments et s'engageant, en position déverrouillée, dans une cavité de blocage prévue sur l'autre élément.

2. Dispositif selon la revendication 1, **caractérisé en ce que** ledit moyen de blocage est désactivé dès déplacement du couvercle (1).

3. Dispositif selon la revendication 1, **caractérisé en ce que** le couvercle (1) est déplacé par pivotement sur son côté opposé au verrou (3), **en ce que** le verrou (3) est coulissant parallèlement au plan du couvercle (1).

4. Dispositif selon la revendication 1, **caractérisé en ce que** l'élément élastique (5) est fixé au boîtier et de forme telle qu'il autorise le coulissement du verrou (3) de la position verrouillée à la position déverrouillée où il s'engage dans une cavité (3C) ménagée dans le couvercle.

5. Dispositif selon la revendication 4, **caractérisé en ce que** ledit élément élastique est une lame et **en ce qu'**une extrémité de la lame (5) est coincée dans une partie (6) solidaire du boîtier (2), la lame (5) ayant une forme courbe afin d'être logée comprimée sous le couvercle (1) et présentant une partie repliée (5C) formant protubérance dirigée vers le couvercle (1), son autre extrémité étant libre.

6. Dispositif selon la revendication1, **caractérisé en ce que** ledit élément élastique (5) est solidaire du couvercle (1) et de forme telle qu'il autorise le coulissement du verrou (3) de la position verrouillée à la position déverrouillée où il s'engage dans une cavité ménagée dans le boîtier (2).

7. Dispositif selon la revendication 6, **caractérisé en ce que** ledit élément élastique (5) pousse le verrou (3) vers sa position verrouillée jusqu'à la position de déverrouillage.

8. Dispositif selon la revendication 7, **caractérisé en ce que** ledit élément élastique est une lame et **en ce qu'**une extrémité de ladite lame (5) est solidaire d'une seconde lame élastique (8) perpendiculaire au sens de déplacement du verrou (3), quand elle n'est pas sollicitée, et en butée contre deux plots (9A,9B) agencés sur le couvercle (1) et ladite lame (5) a une forme courbe afin d'être logée comprimée sous le couvercle (1) et présente une partie repliée (5C) formant protubérance dirigée vers le boîtier (2), son extrémité étant libre.

9. Dispositif selon l'une des revendications 1 à 8, **caractérisé en ce qu'**un ressort de pression (4) solidaire du couvercle (1) sollicite le verrou (3) en position verrouillée.

10. Téléphone portable équipé d'un dispositif de verrouillage/déverrouillage selon l'une des revendications précédentes, **caractérisé en ce que** ledit élément amovible (1) est le couvercle d'un casier formant ledit élément fixe (2) et destiné à recevoir une batterie.
